# EUROPEAN PATENT APPLICATION

(11) **EP 4 841 346 A1**
(43) Date of publication of application: **18.11.2026**
(21) Application number: 25177081.4
(22) Date of filing: 16.05.2025
(51) Int. Cl.: G03F 1/38, G03F 7/00

(54) **PATTERNING DEVICE**

(71) Applicant: ASML Netherlands B.V., 5500 AH Veldhoven (NL)
(72) Inventor: DE KRUIF, Robertus, Cornelis, Martinus, 5500 AH Veldhoven (NL)
(74) Representative: ASML Netherlands B.V.

(57) **Abstract**

A patterning device for a lithographic tool, comprises: a front surface comprising a front conductive region; a back surface comprising a back conductive region; and a side surface between the front surface and the back surface, wherein at least one of the front conductive region and the back conductive region extends onto the side surface; wherein the front conductive region is electrically isolatable from the back conductive region.

## Description

### FIELD

The present invention relates to a lithographic tool component, a patterning device, a patterning device assembly, a lithographic tool, a method for making a patterning device, a method for making a support structure and a method for using a patterning device.

### BACKGROUND

A lithographic tool is a machine constructed to apply a desired pattern onto a substrate. A lithographic tool can be used, for example, in the manufacture of integrated circuits (ICs). A lithographic tool may, for example, project a pattern at a patterning device (e.g., a mask) onto a layer of radiation-sensitive material (resist) provided on a substrate.

To project a pattern on a substrate a lithographic tool may use electromagnetic radiation. The wavelength of this radiation determines the minimum size of features which can be formed on the substrate. A lithographic tool, which uses extreme ultraviolet (EUV) radiation, having a wavelength within the range 4-20 nm, for example 6.7 nm or 13.5 nm, may be used to form smaller features on a substrate than a lithographic tool which uses, for example, radiation with a wavelength of 193 nm.

A patterning device may be used to pattern the radiation. In order to reduce defectivity of the patterning device, the patterning device may have a conductive front side coating and a back side coating layer connected via a conductive path. The connection between the front and back side can negatively affect the process of patterning the patterning device.

### SUMMARY

It is desirable to improve the patterning process of the patterning device, without unduly increasing defectivity of the patterning device.

In an embodiment there is disclosed a lithographic tool component comprising a support structure configured to support a substrate, the support structure comprising:
an electrically conductive support surface for supporting a first surface of the substrate, the first surface comprising a first conductive region; and
a conductive connector electrically connected to the support surface and configured to controllably contact the substrate so as to electrically connect the first conductive region to a second surface of the substrate comprising a second conductive region.

In an embodiment there is disclosed a patterning device for a lithographic tool, the patterning device comprising:
a second surface comprising a second conductive region;
a first surface comprising a first conductive region; and
a side surface between the second surface and the first surface, wherein at least one of the second conductive region and the first conductive region extends onto the side surface;
wherein the second conductive region is electrically isolatable from the first conductive region.

In an embodiment there is disclosed a method for making a support structure for a lithographic tool, the method comprising:
forming an electrically conductive support surface for supporting a first surface of a substrate, the first surface comprising a first conductive region;
electrically connecting a conductive connector to the support surface, such that the connector is configured to controllably contact the substrate so as to electrically connect the first conductive region to a second surface of the substrate comprising a second conductive region.

In an embodiment there is disclosed a method for making a patterning device for a lithographic tool, the method comprising:
forming a second conductive region at a second surface of the patterning device;
forming a first conductive region at a first surface of the patterning device;
wherein the font conductive region and the first conductive region are formed such that:
   at least one of the second conductive region and the first conductive region extends onto a side surface between the second surface and the first surface; and
   the second conductive region is electrically isolatable from the first conductive region.

In an embodiment there is disclosed a method for using a patterning device for a lithographic tool, the method comprising:
supporting the patterning device with a support structure of the lithographic tool; and
electrically connecting a second conductive region of a second surface of the patterning device to a first conductive region of a first surface of the patterning device when the patterning device is already supported by the support structure.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 schematically depicts a plan view of a front surface of a patterning device;
- Figure 3 schematically depicts a plan view of a back surface of the patterning device shown in Figure 2;
- Figure 4 schematically depicts a cross-sectional view of part of the patterning device shown in Figure 2 and Figure 3;
- Figure 5 schematically depicts a cross-sectional view of part of an alternative patterning device;
- Figure 6 schematically depicts a cross-sectional view of an alternative connection for the patterning device shown in Figure 5, for example;
- Figure 7 schematically depicts a cross-sectional view of part of an alternative patterning device; and
- Figure 8 schematically depicts front surface voltage biasing of the patterning device shown in Figure 2, Figure 3 and Figure 4, Figure 5, Figure 6 or Figure 7.

### DETAILED DESCRIPTION

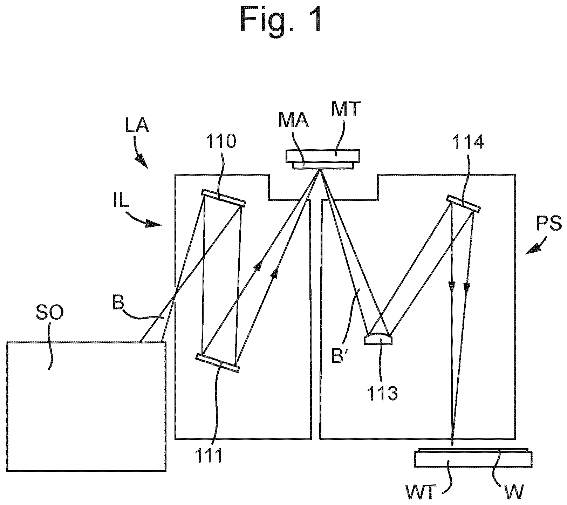

Figure 1 shows a lithographic system comprising a radiation source SO and a lithographic apparatus LA, which is an example of a lithographic tool. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 110 and a facetted pupil mirror device 111. The faceted field mirror device 10 and faceted pupil mirror device 111 together provide the EUV radiation beam B with a desired cross-sectional shape and a desired intensity distribution. The illumination system IL may include other mirrors or devices in addition to, or instead of, the faceted field mirror device 110 and faceted pupil mirror device 111.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 113, 114 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 113, 114 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

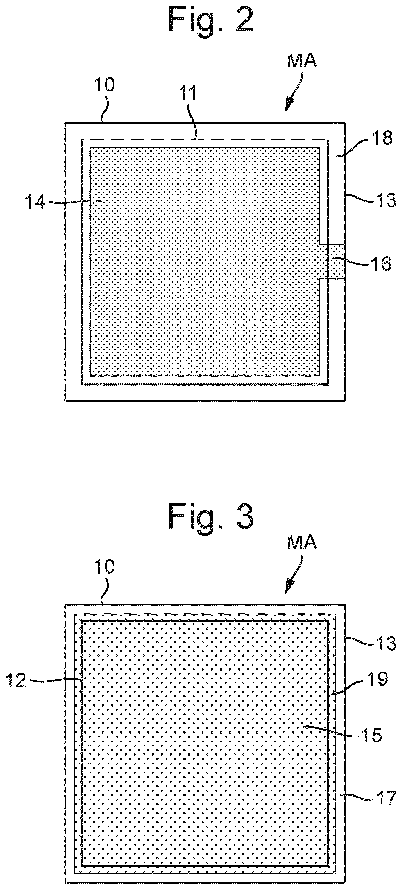

Figure 2 schematically depicts a plan view of a substrate. In the example of Figure 2, the substrate is a patterning device MA. It is not essential for the substrate to be a patterning device MA. In an alternative embodiment the substrate is a blank mask or a wafer, for example. The support structure MT is configured to support the substrate, for example the patterning device MA, blank mask or wafer. The substrate is described primarily in the context of a patterning device, for brevity. The patterning device MA may be of the lithographic apparatus LA shown in Figure 1, for example. Figure 2 schematically depicts a front surface 11 of the patterning device MA.

In an embodiment the patterning device MA is substantially planar. For example, the patterning device MA may have a shape of a plate. The patterning device MA may have two major sides, namely the front surface 11 and the back surface 12 (which may be referred to as a first surface, with the front surface referred to as a second surface). In an embodiment the patterning device MA has one or more side surfaces 13 between the front surface 11 and the back surface 12.

In an embodiment the patterning device MA comprises a substrate 10. The substrate 10 may form the main body of the patterning device MA. In an embodiment the substrate 10 is shaped so as to form the patterning device MA. The patterning device MA may comprise one or more layers, for example coatings, applied to the substrate 10 so as to make the patterning device MA.

As shown in Figure 2, in an embodiment the patterning device MA is substantially square in plan view. It is not essential for the patterning device MA to be square. For example, the patterning device MA may be rectangular or otherwise polygonal, or circular (or more generally elliptical), for example.

As shown in Figure 1, in an embodiment the patterning device MA is supported by the support structure MT during use of the patterning device MA. In an embodiment the patterning device MA is loaded onto the support structure MT. The support structure MT may be configured to hold the patterning device MA. For example, in an embodiment the support structure MT is configured to clamp the patterning device MA to the support structure MT. For example, the support structure MT may be configured to electrostatically clamp the patterning device MA to the support structure MT.

In an embodiment the support structure MT comprises one or more electrodes. One or more power supplies may be configured to apply electric potentials to the one or more electrodes so as to generate an electric field that clamps the patterning device MA to the support structure MT.

As shown in Figure 2, in an embodiment the front surface 11 of the patterning device MA comprises a front conductive region 14. The front surface 11 of the patterning device MA may be an exterior surface of the patterning device MA. In an embodiment the back surface 12 of the patterning device MA faces towards the support structure MT when the patterning device MA is supported by the support structure MT. The front surface 11 may face away from the support structure MT when the patterning device MA is supported by the support structure MT. In an embodiment the front surface 11 and the back surface 12 face away from each other. The front surface 11 and the back surface 12 are provided at opposite sides of the patterning device MA. In an embodiment the front conductive region 14 is part of the external-facing front surface 11 of the patterning device MA. The front conductive region 14 is part of the front surface 11. The front conductive region 14 is electrically conductive. In an embodiment the front conductive region 14 comprises a metal. In an embodiment the front conductive region 14 is formed of a coating. In an embodiment the front conductive region 14 extends onto the front chamfer 18 (see Figure 2). In an alternative embodiment the front conductive region 14 does not extend onto the front chamfer 18.

During manufacture of the patterning device MA, the coating (or other layer) that forms the front conductive region 14 may be applied to the substrate 10 of the patterning device MA. In an embodiment the coating that forms the front conductive region 14 is deposited onto the substrate 10 of the patterning device MA.

Figure 3 schematically depicts another plan view of the substrate which may be the patterning device MA shown in Figure 2. Figure 3 schematically depicts the back surface 12 of the patterning device MA. The back surface 12 may be a surface that is clamped to the support structure MT of the lithographic apparatus LA during use of the patterning device MA.

As shown in Figure 3, in an embodiment the back surface 12 comprises a back conductive region 15 (which may be referred to as a first conductive region, with the front conductive region referred to as a second conductive region). The back conductive region 15 is electrically conductive. For example, in an embodiment the back conductive region 15 comprises a metal. In an embodiment the back conductive region 15 is independent of the front conductive region 14. In an embodiment the back conductive region 15 is conductively isolated from the front conductive region 14.

In an embodiment the back conductive region is formed by a coating that is applied to the back side of the substrate 10 of the patterning device MA. For example, a coating (or other layer) may be applied to the substrate 10 during manufacture of the patterning device MA. In an embodiment the coating is deposited onto the substrate 10 during manufacture of the patterning device MA. In an embodiment the back conductive region 15 extends onto the back chamfer 19 (see Figure 3). In an alternative embodiment the back conductive region 15 does not extend onto the back chamfer 19.

In an embodiment the front conductive region 14 and the back conductive region 15 are formed of different materials. For example, different types of metal may be deposited onto either side of the substrate 10 during manufacture of the patterning device MA so as to form the front conductive region 14 and the back conductive region 15. In an alternative embodiment the front conductive region 14 and the back conductive region 15 are formed of the same material. For example, the same type of metal may be deposited onto both sides of the substrate 10 during manufacture of the patterning device MA so as to form the front conductive region 14 and the back conductive region 15.

As shown in Figure 2 and Figure 3, in an embodiment the patterning device MA comprises a side surface 13. The side surface 13 is between the front surface 11 and the back surface 12 of the patterning device MA. In an embodiment the side surface 13 forms a minor side of the patterning device MA. The side surface 13 may be an exterior surface of the patterning device MA. In an embodiment the side surface 13 comprises at least a portion that is substantially perpendicular to the front surface 11 and the back surface 12 of the patterning device MA. In an embodiment the front surface 11 and the back surface 12 are substantially parallel to each other. The front surface 11 and the back surface 12 may define the plane of the planar patterning device MA. In an embodiment the side surface 13 connects the front surface 11 to the back surface 12 physically.

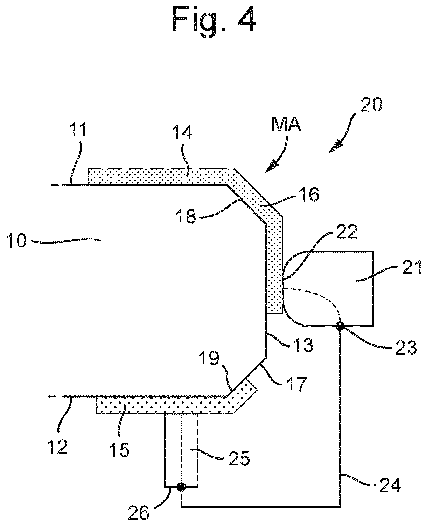

Figure 4 schematically depicts a cross sectional view of part of the substrate which may be a patterning device MA (and alternatively may be a blank mask or a wafer). Figure 4 is a cross sectional view showing the side surface 13 and the parts of the front surface 11 and the back surface 12 that are close to the side surface 13. In practice, the front surface 11 and the back surface 12 are longer than the side surface 13.

As shown in Figure 4, in an embodiment the front conductive region 14 extends onto the side surface 13. That is, as shown in Figure 2 the front conductive region 14 forms part of the front surface 11 of the patterning device MA. As shown in Figure 4, the front conductive region 14 extends over the edge of the patterning device MA between the front surface 11 and the side surface 13, such that the front conductive region 14 extends over at least part of the side surface 13. As shown in Figure 4, in an embodiment part of the side surface 13 has the front conductive region 14, while another part of the side surface 13 is exposed without the front conductive region 14 (i.e. is distanced from the front conductive region 14).

As shown in Figure 2, in an embodiment the front conductive region 14 comprises a protrusion 16. The protrusion 16 may be part of the front conductive region 14 (e.g. part of the coating that forms the front conductive region 14). The protrusion 16 protrudes from a main area of the front conductive region 14. The protrusion 16 protrudes towards the side surface 13 of the patterning device MA.

As shown in Figure 2, in an embodiment the front conductive region 14 comprises a main area which extends over most of the front surface 11 of the patterning device MA when viewed in plan view. In an embodiment the main area of the front conductive region 14 is substantially of similar shape to the patterning device MA. The protrusion 16 extends the front conductive region 14 onto the side surface 13. Apart from the protrusion 16, the rest of the side surface 13 may be distanced from the front conductive region 14.

It is not essential for the front conductive region 14 to extend onto the side surface 13. In an alternative embodiment, the back conductive region 15 extends onto the side surface 13 of the patterning device MA. The whole of the front conductive region 14 may be distanced from the side surface 13.

In a further alternative embodiment, both the front conductive region 14 and the back conductive region 15 extend onto the side surface 13. The parts of the front conductive region 14 and the back conductive region 15 that extend onto the side surface 13 may be distanced from each other on the side surface 13. That is, the front conductive region 14 and the back conductive region 15 are separate from each other on the side surface 13.

In an embodiment the front conductive region 14 is electrically isolatable from the back conductive region 15. In an embodiment the front conductive region 14 is distanced from the back conductive region 15 along the external surface of the patterning device MA. There is a gap between the front conductive region 14 and the back conductive region 15 over the exterior of the substrate 10 that forms the patterning device MA. The front conductive region 14 is insulated from the back conductive region 15 in the patterning device MA itself.

By providing that the front conductive region 14 is electrically isolatable from the back conductive region 15, the patterning device MA can be configured such that there is no electrical connection between the front surface 11 and the back surface 12 of the patterning device MA. An embodiment of the invention is expected to improve the process of patterning the patterning device MA.

In an embodiment a method of making the patterning device MA comprises patterning the patterning device MA. For example, the patterning device MA may be patterned with a pattern. The pattern may be for patterning radiation during use of a lithographic tool such as the lithographic apparatus LA. In an embodiment the process of patterning the patterning device MA comprises shaping the front surface 11 of the patterning device MA.

In an embodiment the process of patterning the patterning device MA is performed when the patterning device MA has a configuration in which the front conductive region 14 is electrically isolated from the back conductive region 15. The patterning process may be performed while there is no connection between the front surface 11 and the back surface 12 of the patterning device MA. Such a connection between the front surface 11 and the back surface 12 can undesirably affect the patterning process of the patterning device MA. By performing the patterning process when there is no such connection, the patterning process can be improved.

In an embodiment the front conductive region 14 and/or the back conductive region 15 are applied before patterning the patterning device MA. For example, the one or more coatings that form the front conductive region 14 and the back conductive region 15 may be deposited before the step of patterning the patterning device MA. An embodiment of the invention is expected to maintain the accuracy of patterning the patterning device MA. By applying the coatings before patterning the patterning device MA, the deposition of the coatings cannot adversely reduce the accuracy or precision of the patterning of the patterning device MA.

By providing a front conductive region 14 and a back conductive region 15, it is possible to connect the front conductive region 14 to the back conductive region 15 via a conductive path. That is, although the front conductive region 14 is electrically isolatable from the back conductive region 15, the front conductive region 14 can be electrically connected to the back conductive region 15. In an embodiment the electrical connection between the front conductive region 14 and the back conductive region 15 is selectively made at a time when it has a technical advantage. For example, the front conductive region 14 and the back conductive region 15 may be isolated from each other during manufacture of the patterning device MA in particular during patterning of the patterning device MA. When the patterning device MA is to be used in the lithographic apparatus LA, the front conductive region 14 may be electrically connected to the back conductive region 15. By providing an electrical connection between the front conductive region 14 and the back conductive region 15 during use of the lithographic apparatus LA, the defectivity of the patterning device MA may be reduced. An embodiment of the invention is expected to improve the patterning process of the patterning device MA without unduly reducing defectivity of the patterning device MA.

As shown in Figure 4, in an embodiment the patterning device MA comprises an insulative region 17. The insulative region 17 separates the front conductive region 14 from the back conductive region 15. The insulative region is part of a surface of the patterning device MA. The insulative region 17 is part of an exterior of the patterning device MA. The insulative region 17 electrically insulates the front conductive region 14 from the back conductive region 15 over the external surface of the patterning device MA. In an embodiment the insulative region 17 forms a surface of the substrate 10 that forms the patterning device MA.

As shown in Figure 4, in an embodiment the insulative region 17 comprises part of the side surface 13 of the patterning device MA. In an embodiment the insulative region 17 extends around the perimeter of the patterning device MA in plan view. In an embodiment the insulative region 17 substantially surrounds the back conductive region 15, as shown in Figure 3. In an embodiment the insulative region 17 substantially surrounds the front conductive region 14. In an embodiment the insulative region 17 is sufficiently wide to avoid undesirable electrical breakdown between the front conductive region 14 and the back conductive region 15 during manufacture of the patterning device MA.

As shown in Figure 4, in an embodiment only one of the front conductive region 14 and the back conductive region 15 extends onto the side surface 13. In the arrangement shown in Figure 2, Figure 3 and Figure 4, only the front conductive region 14 extends onto the side surface 13. That is, only the front conductive region 14 extends onto a surface (i.e. the side surface 13) that extends substantially perpendicularly to the plane of the front surface 11 and the back surface 12. In the arrangement shown in Figure 2, Figure 3 and Figure 4, the back conductive surface 15 stops short of reaching the side surface 13.

However, it is not essential for only one of the front conductive region 14 and the back conductive region 15 to extend onto the side surface 13. In an alternative embodiment, both the front conductive region 14 and the back conductive region 15 extend onto the side surface 13. When both the front conductive region 14 and the back conductive region 15 extend onto the side surface 13, the front conductive region 14 and the back conductive region 15 remain separated by, for example, an insulative region 17. The insulative region 17 extends on the side surface 13 between the front conductive region 14 and the back conductive region 15.

As shown in Figure 2 and Figure 4, in an embodiment the patterning device MA comprises a front chamfer 18. The chamfer 18 may be provided at an edge connecting the front surface 11 to the side surface 13. As shown in Figure 4, the front chamfer 18 may be angled relative to the front surface 11 and the side surface 13. As shown in Figure 2, in an embodiment the front chamfer 18 extends along all edges of the front surface 11 of the patterning device MA. The front chamfer 18 may extend around the perimeter of the patterning device MA. In an alternative embodiment the front chamfer 18 may be provided on a subset of the edges of the front surface 11 of the patterning device MA. In a further alternative embodiment, the front chamfer 18 may be omitted. The front surface 11 may connect to the side surface 13 at a sharp edge, for example.

By providing the front chamfer 18, the possibility of an undesirably strong electric field at a sharp edge of the patterning device MA may be reduced. An embodiment of the invention is expected to reduce the possibility of undesirable electrical breakdown. In an embodiment the front chamfer 18 forms a smooth curve when viewed in cross section.

As shown in Figure 4, and Figure 2, in an embodiment the front conductive region 14 extends over part of the front chamfer 18. For example, the protrusion 16 of the front conductive region 14 may extend across the front chamfer 18. In an embodiment most of the length of the front chamfer 18 is distanced from the front conductive region 14. As shown in Figure 2, the front chamfer 18 may extend substantially along the whole length of the patterning device MA. Only the part corresponding to the position of the protrusion 16 of the front conductive region 14 is covered by the front conductive region 14. The rest of the length of the front chamfer 18 is distanced from the front conductive region 14. An embodiment of the invention is expected to reduce the amount of material required to form the front conductive region 14. An embodiment of the invention is expected to reduce the cost of making the patterning device MA.

It is not essential for most of the length of the front chamfer 18 to be distanced from the front conductive region 14. In an alternative embodiment, most of the length of the front chamfer 18 may be covered by the front conductive region 14.

As shown in Figure 3 and Figure 4, in an embodiment the patterning device MA comprises a back chamfer 19 (which may be referred to as a first chamfer, with the front chamfer referred to as a second chamfer). The back chamfer 19 may be provided at an edge connecting the back surface 12 to the side surface 13.

As shown in Figure 3, in an embodiment the back chamfer 19 extends around substantially the whole perimeter of the substrate 10 of the patterning device MA. In an alternative embodiment, the back chamfer 19 extends around a subset of the sides of the patterning device MA when viewed in plan view. For example, the back chamfer 19 may be provided only at the edge between the back surface 12 and the side surface 13 at which the front conductive region 14 is electrically connectable to the back conductive region 15.

In an embodiment the back chamfer 19 is configured to reduce sharp edges at the external surface of the patterning device MA. An embodiment of the invention is expected to reduce the possibility of undesirably strong electric fields at sharp edges of the patterning device MA. An embodiment of the invention is expected to reduce the possibility of electrical breakdown.

As shown in Figure 3, in an embodiment the back conductive region 15 extends onto the back chamfer 19 over most of the length of the back chamfer 19. That is, the back conductive region 15 may form a shape that extends beyond the edge between the back surface 12 and the back chamfer 19. The back conductive region 15 extends beyond the edge of the back surface 12 around substantially the whole parameter of the back surface 12, as shown in Figure 3.

As shown in Figure 4, in an embodiment the support structure MT comprises a burl 25. In Figure 4, only one burl 25 is shown. In an embodiment the support structure MT comprises a plurality of burls 25. The burls 25 may protrude towards the back surface 12 of the patterning device MA.

In an embodiment the burls 25 comprises respective distal ends 26. The distal ends 26 may be arranged in a plane. The patterning device MA may be supported at the plane in which the distal ends 26 of the burls 25 are provided. For example, the distal ends 26 may be supported at the support structure MT of the lithographic apparatus LA. The distal ends 26 may form a support surface for supporting the patterning device MA.

As shown in Figure 4, in an embodiment the burl 25 is electrically connected to the back conductive region 15. The burl 25 may be arranged to contact the back conductive region 15. For example, the burl 25 may protrude to the back conductive region 15 of the patterning device MA.

By providing that the burl 25 is electrically connected to the back conductive region 15, the burl 25 may facilitate the back conductive region 15 to be electrically connected to another component. For example, the burl 25 may make it easier to electrically connect the back conductive region 15 to the front conductive region 14 when it is desirable for there to be an electrical connection between the front surface 11 and the back surface 12 of the patterning device MA.

For example, Figure 4 schematically depicts a patterning device assembly 20. The patterning device assembly 20 may be comprised in a lithographic apparatus LA, for example of the type shown in Figure 1. The patterning device assembly 20 comprises the patterning device MA. The patterning device assembly 20 may comprise one or more further components in addition to the patterning device MA.

As shown in Figure 4, in an embodiment the patterning device assembly 20 comprises a electrically conductive connector 21 (which may be referred to as a conductive pusher). The electrically conductive connector 21 is electrically conductive. For example, the electrically conductive connector 21 may comprise a metal.

In an embodiment the electrically conductive connector 21 is configured to selectively contact the at least one of the front conductive region 14 and the back conductive region 15 on the side surface 13 so as to selectively electrically connect the front conductive region 14 to the back conductive region 15. For example, Figure 4 shows an arrangement in which only the front conductive region 14 extends onto the side surface 13. The electrically conductive connector 21 is configured to selectively physically contact the front conductive region 14 on the side surface 13. When the electrically conductive connector 21 physically contacts the side surface 13 so as to make contact with the front conductive region 14, the front conductive region 14 is brought into electrical connection with the back conductive region 15.

As shown in Figure 4, in an embodiment the patterning device assembly 20 comprises a flexible conductor 24 (which may be referred to as a flexible connector). For example, the flexible conductor 24 may comprise a wire. The flexible conductor 24 is configured to electrically connect the electrically conductive connector 21 to one of the front conductive region 14 and the back conductive region 15. For example, in the arrangement shown in Figure 4, the flexible conductor 24 is configured to electrically connect the electrically conductive connector 21 to the back conductive region 15, for example via the burl 25.

When the electrically conductive connector 21 contacts the front conductive region 14, the electrically conductive connector 21 electrically connects the front conductive region 14 to the back conductive region 15.

In an alternative embodiment, the back conductive region 15 may extend onto the side surface 13. The front conductive region 14 may be distanced from the side surface 13. The electrically conductive connector 21 may be electrically connected, for example via the flexible conductor 24, to the front conductive region 14. The electrically conductive connector 21 may be brought into physical contact with the back conductive region 15 at the side surface 13 of the patterning device MA. When the electrically conductive connector 21 is brought into contact with the back conductive region 15 at the side surface 13, the front conductive region 14 is brought into contact with the back conductive region 15. In other words, the electrically conductive connector 21 may interact with the front conductive region 14 and the back conductive region 15 in the opposite sense from what is shown in Figure 4.

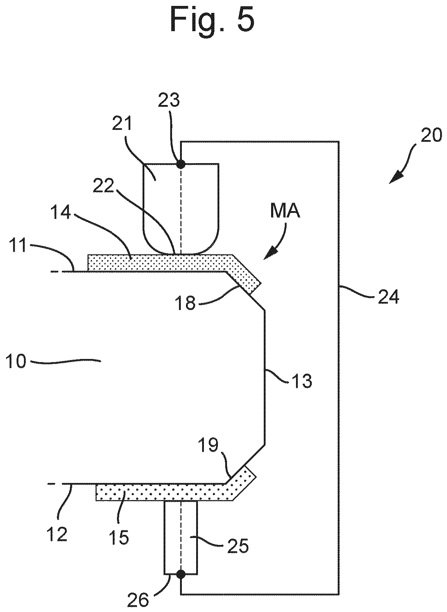

As shown in Figure 5, in an alternative embodiment the electrical conductive connector 21 may be positioned such that it interacts with the front conductive region 14 on the front surface 11. This can help to avoid the need of a coating protrusion onto the side surface 13 of the patterning device MA.

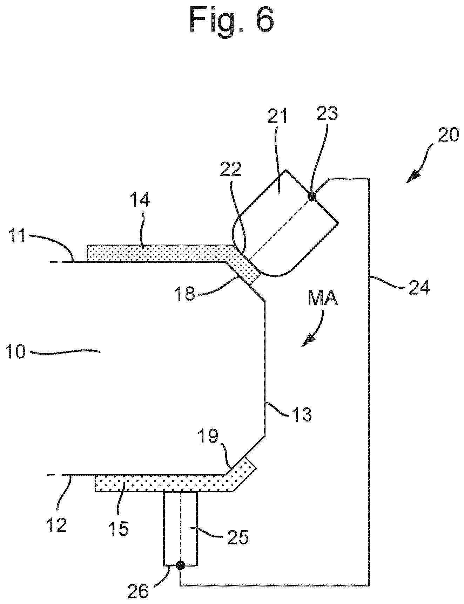

As shown in Figure 6, in an alternative embodiment the electrical conductive connector 21 may be positioned such that it interacts with the front conductive region 14 on the front chamfer 18. This can help to avoid the need of a coating protrusion onto the side surface 13 of the patterning device MA.

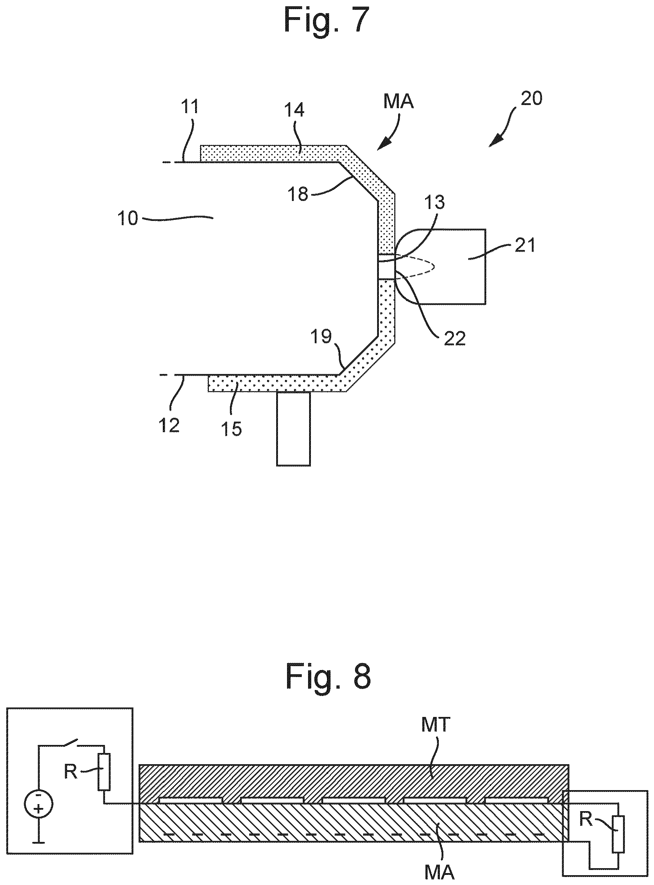

In a further alternative embodiment, both the front conductive region 14 and the back conductive region 15 may extend onto the side surface 13, albeit distanced from each other. The electrically conductive connector 21 may be electrically connected to one of the front conductive region 14 and the back conductive region 15 via the flexible conductor 24. The electrically conductive connector 21 may be brought into contact with the other of the front conductive region 14 and the back conductive region 15 so as to form the electrical connection. Alternatively, the flexible conductor 24 may not be necessary. For example, as shown in Figure 7, the electrically conductive connector 21 may be brought into contact substantially simultaneously with both the front conductive region 14 and the back conductive region 15 at the side surface 13 so as to form the electrical connection between the front surface 11 and the back surface 12.

In an embodiment the electrically conductive connector 21 is brought into contact with the side surface 13 when the patterning device MA is already supported by the support structure MT. The patterning device MA may be supported by the support structure MT before the electrical connection between the front surface 11 and the back surface 12 of the patterning device MA is formed.

By selectively forming and breaking the electrical connection between the surface 11 and the back surface 12 of the patterning device MA, the electrical connection may be avoided during the manufacturing process of the pattern on the patterning device MA and subsequently formed when a patterning device MA is used in the lithographic apparatus LA. An embodiment of the invention is expected to achieve the technical advantages of having such an electrical connection without suffering from any of the disadvantages of having such an electrical connection.

As shown in Figure 4, in an embodiment the electrically conductive connector 21 comprises an abutment portion 22, which may be referred to as a head. The abutment portion 22 is configured to abut against the side surface 13. As shown in Figure 4, in an embodiment the electrically conductive connector 21 comprises a connector 23. The connector 23 is configured to electrically connect the electrically conductive connector 21 to the flexible conductor 24.

Figure 8 schematically depicts front surface voltage biasing of the patterning device MA shown in Figure 2, Figure 3 and Figure 4. In an embodiment the controller is configured to bias the patterning device MA with a negative offset voltage between pulses of EUV radiation. The electrical connection to the front side of the patterning device MA facilitates the biasing. In an embodiment the controller is configured to control supply of an electrical current to boas the patterning device MA. By electrically connecting the opposite sides of the patterning device MA, it is not necessary to directly contact the front side. The defectivity risk may be reduced.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. The lithographic tool may be an inspection tool, for example. Embodiments of the invention may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A lithographic tool component comprising a support structure configured to support a substrate, the support structure comprising:
an electrically conductive support surface for supporting a first surface of the substrate, the first surface comprising a first conductive region; and
a conductive connector electrically connected to the support surface and configured to controllably contact the substrate so as to electrically connect the first conductive region to a second surface of the substrate comprising a second conductive region.

2. The support structure of claim 1, comprising:
a plurality of burls having distal ends in a plane for supporting the first surface, wherein the support surface comprises the distal end of at least one of the burls, the distal end being electrically conductive and electrically connected to the connector.

3. The support structure of claim 1 or 2, wherein the connector is configured to controllably contact the second conductive region extending onto a side surface of the substrate so as to electrically connect the first conductive region to the second conductive region.

4. The support structure of claim 1 or 2, wherein the connector is configured to controllably contact the second surface of the substrate so as to electrically connect the first conductive region to the second conductive region.

5. The support structure of any preceding claim, comprising:
a flexible conductor configured to electrically connect to the connector so as to form at least part of an electrical path between the connector and the first conductive region.

6. The support structure of any preceding claim, comprising:
an actuator configured to actuate the connector so as to controllably contact the connector with the substrate.

7. A patterning device for a lithographic tool, the patterning device comprising:
a second surface comprising a second conductive region;
a first surface comprising a first conductive region; and
a side surface between the second surface and the first surface, wherein at least one of the second conductive region and the first conductive region extends onto the side surface;
wherein the second conductive region is electrically isolatable from the first conductive region.

8. The patterning device of claim 7, comprising an insulative region separating the second conductive region from the first conductive region.

9. The patterning device of claim 7 or 8, wherein only one of the second conductive region and the first conductive region extends onto the side surface.

10. The patterning device of any of claims 7-9, comprising:
a second chamfer at an edge connecting the second surface to the side surface, wherein most of a length of the second chamfer is distanced from the second conductive region.

11. The patterning device of any of claims 7-10, comprising:
a first chamfer at an edge connecting the first surface to the side surface, wherein the first conductive region extends onto the first chamfer over most of a length of the first chamfer.

12. A patterning device assembly comprising:
the support structure of any of claims 1-6; and
a patterning device comprising:
a second surface comprising a second conductive region;
a first surface comprising a first conductive region;
wherein the connector is configured to controllably contact the patterning device so as to electrically connect the first conductive region to the second conductive region.

13. A patterning device assembly comprising:
the support structure of any of claims 1-6; and
the patterning device of any of claims 7-11;
wherein the connector is configured to controllably contact the patterning device so as to electrically connect the first conductive region to the second conductive region.

14. A lithographic tool comprising:
the patterning device assembly of claim 12 or 13, wherein the lithographic tool is arranged to project a pattern from the patterning device onto a substrate.

15. The lithographic tool of claim 14, comprising:
an illumination system configured to condition a radiation beam, wherein the patterning device is capable of imparting the radiation beam with a pattern in its cross-section to form a patterned radiation beam;
a projection system configured to project the patterned radiation beam onto a substrate; and
a substrate table constructed to hold the substrate.

16. A method for making a support structure for a lithographic tool, the method comprising:
forming an electrically conductive support surface for supporting a first surface of a substrate, the first surface comprising a first conductive region;
electrically connecting a conductive connector to the support surface, such that the connector is configured to controllably contact the substrate so as to electrically connect the first conductive region to a second surface of the substrate comprising a second conductive region.

17. A method for making a patterning device for a lithographic tool, the method comprising:
forming a second conductive region at a second surface of the patterning device;
forming a first conductive region at a first surface of the patterning device;
wherein the font conductive region and the first conductive region are formed such that:
at least one of the second conductive region and the first conductive region extends onto a side surface between the second surface and the first surface; and
the second conductive region is electrically isolatable from the first conductive region.

18. The method of claim 17, wherein at least one of the second conductive region and the first conductive region is formed by applying an electrically conductive material to a substrate of the patterning device.

19. The method of claim 17 or 18, comprising:
patterning the patterning device with a pattern for patterning radiation during use of the lithographic tool.

20. The method of claim 19, wherein the patterning process is performed after forming the second conductive region and the second conductive region.

21. The method of claim 20, wherein the patterning process is performed when the second conductive region is isolated from the first conductive region.

22. A method for using a patterning device for a lithographic tool, the method comprising:
supporting the patterning device with a support structure of the lithographic tool; and
electrically connecting a second conductive region of a second surface of the patterning device to a first conductive region of a first surface of the patterning device when the patterning device is already supported by the support structure.

23. The method of claim 22, wherein the support structure is configured to support the patterning device by clamping the patterning device.

24. The method of claim 23, wherein the support structure is configured to electrostatically clamp the patterning device.

25. The method of any of claim 22-24, wherein the second conductive region is electrically connected to the first conductive region by contacting a conductive connector to a side surface of the patterning device, between the second surface and the first surface, onto which at least one of the second conductive region and the first conductive region extends.

26. The method of claim 25, wherein the connector is already electrically connected to one of the second conductive region and the first conductive region, such that when the connector contacts the side surface onto which the other of the second conductive region and the first conductive region extends, the second conductive region is electrically connected to the first conductive region.

27. The method of any of claims 22-26, comprising:
patterning a beam of radiation with the patterning device; and
projecting the patterned beam of radiation onto a substrate.
